# EUROPÄISCHE PATENTSCHRIFT

(11) **EP 2 592 914 B1**
(45) Veröffentlichungstag und Bekanntmachung des Hinweises auf die Patenterteilung: **06.05.2015**
(21) Anmeldenummer: 11464021.2
(22) Anmeldetag: 14.11.2011
(51) Int. Cl.: H01R 12/00

(54) **Klemmelement**
Clamping element
Elément de serrage

(43) Veröffentlichungstag der Anmeldung: 15.05.2013
(73) Patentinhaber: Continental Automotive GmbH, 30165 Hannover (DE)
(72) Erfinder: Eroilor de la Tisa, Tibor Bakos, 300576 Timisoara (RO)

(56) Entgegenhaltungen:
- EP-A1- 0 975 057
- GB-A- 1 040 998
- JP-A- 2008 153 137
- US-A- 4 629 267
- US-A- 4 688 149

## Beschreibung

Die Erfindung betrifft ein Klemmelement zur Befestigung eines elektrischen Leiters an einer Leiterplatte. Die Erfindung betrifft weiterhin ein Befestigungssystem für einen elektrischen Leiter an einer Leiterplatte, sowie ein Verfahren zur Befestigung eines elektrischen Leiters an einer Leiterplatte.

Zum Beispiel in der Automobiltechnik werden seit vielen Jahren elektronischen Schaltkreise eingesetzt, die zumeist auf Leiterplatten angeordnet sind und zur Steuerung einer Vielzahl von Funktionen im Automobil dienen. Mit der vermehrten Entwicklung elektrisch angetriebener Fahrzeuge verstärkt sich diese Tendenz, wobei neben der Anforderung an die Zuverlässigkeit der Schaltkreise vermehrt der Anspruch an die Zuleitung, Steuerung und Übertragung von Strömen mit hohen Stromstärken entsteht. Bislang wurden die Leiterplatten mit den elektrischen Leitern durch Lötverfahren verbunden. Diese Verfahren sind relativ schwer zu automatisieren und an den Lötstellen kommt es in der Regel zu erhöhten Überganswiderständen, die gerade bei der Übertragung von elektrischen Strömen mit hoher Stromstärke zu Erwärmungen der Verbindungsstellen führen können. Die Erwärmung dieser Verbindungsstellen zwischen der Leiterplatte und dem elektrischen Leiter kann zur Zerstörung der Verbindung führen, was in jedem Fall vermieden werden muss. Nach dem Stand der Technik werden zur Vermeidung solcher Überhitzungen der Verbindung zwischen dem elektrischen Leiter und der Leiterplatte einfach elektrischen Leitungen mit höherem Querschnitt und größere Lötstellen auf der Leiterplatte verwendet. Bei der Vielzahl von Verbindungsstellelen zwischen elektrischen Leitern und Leiterplatten in modernen Kraftfahrzeugen hat diese Überdimensionierung der Leiter und der Verbindungsstellen einen nicht unerheblichen Einfluss sowohl auf das Gewicht des Gesamtfahrzeuges als auch auf die Herstellungskosten der elektrischen und elektronischen Systeme.

Der Erfindung liegt daher das Problem zugrunde, das bekannte Verfahren zur Befestigung eines elektrischen Leiters an einer Leiterplatte derart weiter zu bilden, dass eine möglichst hohe Automatisierung bei der Befestigung eines elektrischen Leiters an einer Leiterplatte erreicht werden kann, wobei eine möglichst kostengünstige Lösung gefunden werden soll.

Dieses Problem wird erfindungsgemäß durch die Merkmale des unabhängigen Anspruchs 1 gelöst. Die Lösung des Problems hat in erfinderischer Weise zu einem Klemmelement geführt, wobei das Klemmelement als Stanzblechteil ausgebildet ist und mindestens zwei Klemmflügel sowie einen Klemmsteg, der zwischen den Klemmflügeln angeordnet ist, aufweist, wobei der Klemmsteg derart abbiegbar ist, dass die Klemmflügel den Leiter einklemmen, wobei an den Klemmflügeln mindestens einen Sicherungskralle ausgebildet ist, die in die Leiterplatte einpressbar ist. Ein solches Klemmelement ist sehr kostengünstig und vollautomatisiert herstellbar. Mit dem Klemmelement kann der Leiter sicher und langlebig an der Leiterplatte befestigt werden, wobei eine hervorragende elektrische Verbindung zwischen dem Leiter und der Leiterplatte erreicht wird, die sich durch einen besonders geringen Übergangswiderstand von dem Leiter zu der Leiterplatte auszeichnet. Dadurch kann über den elektrischen Leiter ein relativ hoher Strom an die Leiterplatte übertragen werden, ohne dass es im Bereich der Befestigung des Leiters an der Leiterplatte zu einer ungewollten Überhitzung dieser Befestigungs- und Verbindungsstelle kommt.

Bei der Erfindung weisen die Klemmflügel eine Leitertasche auf, die den Leiter umschließt. In dieser Leitertasche wird der elektrischen Leiter besonders sicher gelagert, wobei die Leitertasche an ihren Rändern scharfkantig ausgebildet sein kann, womit sie sich zusätzlich in die Oberfläche des Leiters eingräbt und damit ein Verrutschen des Leiters völlig verhindern.

Bei einer Weiterbildung der Erfindung weisen die Klemmflügel einen Klemmflügelbogen auf, der eine gefederte Lagerung des Leiters ermöglicht. Durch die gefederte Lagerung des Leiters ist der Druck den der Klemmflügel auf den Leiter ausübt genau vorherbestimmbar und dieser Druck bleibt über die Lebensdauer der Verbindung zwischen dem Leiter und der Leiterplatte erhalten. Damit wird die Verbindung sehr langlebig und belastbar. Darüber hinaus gewährleisten die Klemmflügelbögen eine genaue und stabile Platzierung des Klemmelementes in dem Aufnahmeelement.

Zudem ist es vorteilhaft, wenn die Klemmflügel eine Kontaktfläche aufweisen. Diese Kontaktfläche kann zum Beispiel von den Klemmflügelbögen begrenzt werden. Die Kontaktfläche stellt eine besonders widerstandsarme elektrische Verbindung zwischen dem elektrischen Leiter und der Leiterplatte sicher.

Die Aufgabe wird darüber hinaus durch ein Befestigungssystem für einen elektrischen Leiter an einer Leiterplatte, mit einem erfindungsgemäßen Klemmelement gelöst, wobei an der Leiterplatte ein Aufnahmeelement mit einer elektrisch leitenden Oberfläche ausgebildet ist, in das das Klemmelement einführgeführt ist.

Dabei ist es vorteilhaft, wenn das Aufnahmeelement U-förmig ausgebildet ist, da sich das Klemmelement besonders gut in ein U-förmiges Aufnahmeelement einfügt, was den elektrischen Übergangswiderstand besonders gering hält.

Weiterhin wird die Aufgabe durch ein Verfahren zur Befestigung eines elektrischen Leiters an einer Leiterplatte gelöst, wobei der elektrische Leiter in ein erfindungsgemäßes Klemmelement eingeklemmt wird, was durch ein Abbiegen der Klemmsteges erreicht wird, wobei der elektrische Leiter zwischen den Klemmflügeln eingeklemmt wird, wonach das Klemmelement in ein Aufnahmeelement eingeschoben wird und wonach die Sicherungskralle in die Leiterplatte eingepresst oder eingeschlagen wird. Ein solches Verfahren lässt sich vollständig automatisieren, wodurch es besonders kostengünstig ist und Fehler bei der Verbindung des elektrischen Leiters mit der Leiterplatte fast vollständig vermieden werden können.

Die Erfindung lässt zahlreiche Ausführungsformen zu. Zur weiteren Verdeutlichung ist die Erfindung in den Zeichnungen näher dargestellt und wird nachfolgend beschrieben. Die Zeichnungen zeigt in:
- Fig. 1: ein Klemmelement mit zwei Klemmflügeln,
- Fig. 2: eine Ausgestaltung des in Fig. 1 dargestellten Klemmelementes,
- Fig. 3: das Klemmelement mit einem abgebogenen Klemmsteg,
- Fig. 4: das Klemmelement zur Befestigung eines elektrischen Leiters aus einer weiteren Perspektive,
- Fig. 5: das Klemmelement mit einem darin angeordneten elektrischen Leiter,
- Fig. 6: ein Befestigungssystem für einen elektrischen Leiter an einer Leiterplatte,
- Fig. 7: eine Draufsicht auf das in das Aufnahmeelement eingeführte Klemmelement,
- Fig. 8: eine perspektivische Ansicht des in das Aufnahmeelement eingeführten Klemmelementes.

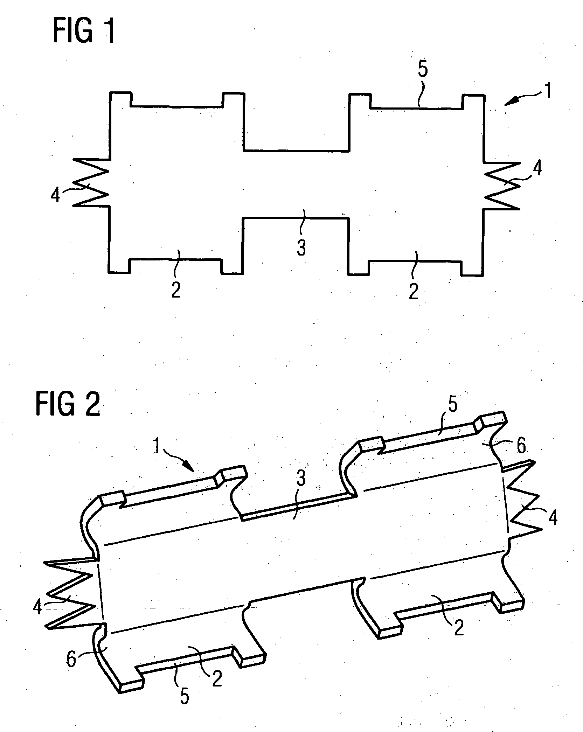

Fig. 1 zeigt ein Klemmelement 1 mit zwei Klemmflügeln 2. Die zwei Klemmflügel 2 sind mittels des Klemmsteges 3 miteinander verbunden. An den Klemmflügeln 2 sind Sicherungskrallen 4 zu erkennen, die hier beispielhaft als dreizackige Sicherungskrallen 4 ausgebildet sind. Darüber hinaus sind an den Klemmflügeln 2 jeweils zwei Leitertaschen 5 zu erkennen. Das Klemmelement 1 selber ist als metallisches Stanzblechteil ausgebildet, welches extrem kostengünstig und einfach hergestellt werden kann.

In Fig. 2 ist eine Weiterbildung des in Fig. 1 dargestellten Klemmelementes zu erkennen. Das Klemmelement 1 weist wiederum zwei Klemmflügel 2 auf, die durch den Klemmsteg 3 miteinander verbunden sind. Die Klemmflügel 2 sind nun mit Klemmflügelbögen 6 ausgestattet, die zum einen eine elastische Lagerung eines hier nicht dargestellten elektrischen Leiters gewährleisten und zum anderen die Kontaktfläche 8 begrenzen, womit gewährleistet wird, dass das Klemmelement 1 in der in den nachfolgenden Figuren dargestellten Leiterplatte 9 sicher gelagert ist.

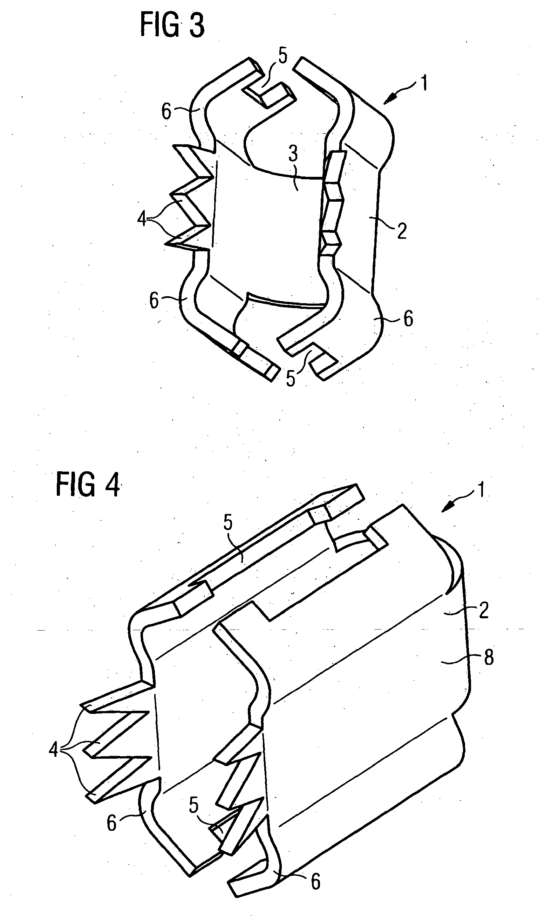

Fig. 3 zeigt das Klemmelement 1, wobei der Klemmsteg 3 derart abgebogen ist, dass die Klemmflügel 2 den hier nicht dargestellten Leiter 7 vorteilhaft einklemmen können. Hier ist deutlich zu erkennen, dass die Leitertaschen 5 Hohlräume bilden, in denen der elektrische Leiter 7 eingefügt sein kann. Bei dem elektrischen Leiter 7 kann es sich z. B. um einen metallischen Draht handeln oder auch um ein metallisches Stanzblechteil, welches mit der Leiterplatte verbunden werden soll. Darüber hinaus kann mit dem Klemmelement 1 z. B. auch ein aus Kohlefasern aufgebauter elektrischer Leiter mit der Leiterplatte verbunden werden.

In Fig. 4 ist das Klemmelement 1 zur Befestigung eines elektrischen Leiters 7 an einer Leiterplatte 9 aus einer anderen Perspektive dargestellt. Auch hier sind die Klemmflügel 2 zu erkennen, an denen jeweils eine Sicherungskralle 4 ausgebildet ist. In den Klemmflügeln 2 finden sich die Klemmflügelbögen 6 sowie die Leitertaschen 5. Deutlich zu erkennen ist die Kontaktfläche 8, die auf den Klemmflügeln 2 durch die Klemmflügelbögen 6 begrenzt wird.

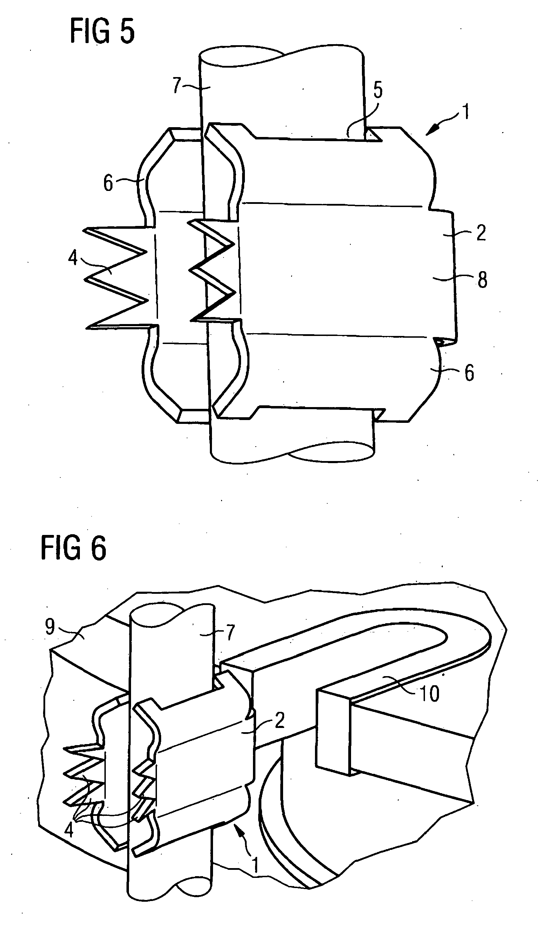

Fig. 5 zeigt das Klemmelement 1 mit einem darin angeordneten elektrischen Leiter 7. Das als Stanzblechteil ausgebildete Klemmelement 1 weist wie schon in den vorhergehenden Figuren zwei Klemmflügel 2 auf, die mit einem Klemmsteg 3 miteinander verbunden sind, wobei der Klemmsteg 3 zwischen den Klemmflügeln 2 angeordnet ist. Der Klemmsteg 3 ist derart abgebogen, dass die Klemmflügel 2 den Leiter 7 einklemmen. An den Klemmflügeln 2 sind jeweils die Sicherungskrallen 4 zu erkennen. Darüber hinaus sind an den Klemmflügeln 2 die Leitertaschen 5 zu erkennen, in denen der elektrische Leiter 7 sicher gelagert ist. Die Leitertaschen 5 umschließen dabei den Leiter 7. Die Klemmflügel 2 weisen weiterhin Klemmflügelbögen 6 auf, die eine gefederte Lagerung des Leiters 7 ermöglichen. Hierzu wird ein gewisser Druck auf den elektrischen Leiter 7 ausgeübt, so dass sich die Ränder der Leitertaschen 5 in die Oberfläche des elektrischen Leiters 7 eingraben und ihn damit sicher an dem Klemmelement 1 befestigen. Die Klemmflügelbögen 6 begrenzen die Kontaktfläche 8, die ein Bestandteil des Klemmflügels 2 ist.

Ein Befestigungssystem für einen elektrischen Leiter 7 an einer Leiterplatte 9 mit einem Klemmelement 1 nach den Figuren 1 bis 5 ist in Fig. 6 dargestellt. Zu erkennen ist wiederum das Klemmelement 1 mit den zwei Klemmflügeln 2, die durch den Klemmsteg 3 miteinander verbunden sind, wobei an den Klemmflügeln 2 Sicherungskrallen 4 ausgebildet sind. Die Leitertaschen 5 an den Klemmflügeln 2 sorgen für eine sichere Befestigung des elektrischen Leiters 7 im Klemmelement 1. Darüber hinaus sorgen die Klemmflügelbögen 6 für einen stetigen Anpressdruck der Ränder der Leitertaschen 5 an den elektrischen Leiter 7. In Fig. 6 ist weiterhin die Leiterplatte 9 zu erkennen, an deren Rand ein Aufnahmeelement 10 für das Klemmelement 1 ausgebildet ist. In diesem Beispiel ist das Aufnahmeelement 10 U-förmig ausgebildet. Es ist aber auch denkbar, das Aufnahmeelement 10 z. B. in einer viereckigen Form auszubilden. Zumindest die Oberfläche des Aufnahmeelementes 10 besteht aus einem elektrisch leitenden Material, z. B. aus einem Metall. Das Klemmelement 1 ist nach seiner Abbiegung um den elektrischen Leiter 7 in eine Form gebracht, die exakt mittels Presspassung in das Aufnahmeelement 10 eingeführt werden kann. Durch die Klemmflügelbögen 6 kann die Kontaktfläche 8 des Klemmelementes 1 sehr präzise in das Aufnahmeelement 10 eingeführt werden. Nach dem Einführen des Klemmelementes 1 in das Aufnahmeelement 10 werden die Sicherungskrallen 4 in die Leiterplatte 9 eingepresst oder eingeschlagen. Damit entsteht eine dauerhafte elektrische und mechanische Verbindung zwischen dem elektrischen Leiter 7 und dem Aufnahmeelement 10 der Leiterplatte 9.

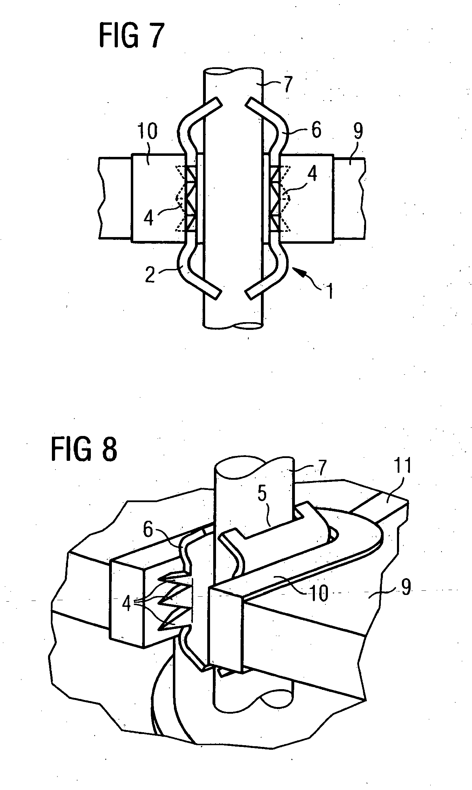

Fig. 7 zeigt eine Draufsicht auf das in das Aufnahmeelement 10 eingeführte Klemmelement 1. Im Klemmelement 1 ist der elektrische Leiter 7 eingeklemmt, wobei deutlich zu erkennen ist, dass die Klemmflügelbögen 6 die Leitertasche 5 gegen den elektrischen Leiter 7 pressen. Die an den Klemmflügeln 2 ausgebildeten Sicherungskrallen 4 sind seitlich im Bereich des Aufnahmeelementes 10 in die Leiterplatte 9 eingeschlagen. Dadurch entsteht eine dauerhafte mechanische und elektrisch leitende Verbindung zwischen dem Klemmelement 1 und dem Aufnahmeelement 10 der Leiterplatte 9.

Fig. 8 zeigt eine perspektivische Ansicht des in das Aufnahmeelement 10 eingeführten Klemmelementes 1. An dem Aufnahmeelement 10 ist eine Leiterbahn 11 zu erkennen, die auf der Leiterplatte 9 ausgebildet ist und die den elektrischen Strom von dem elektrischen Leiter 7 über das Klemmelement 1 und das Aufnahmeelement 10 hin zu weiteren elektronischen und elektrischen Bauteilen führt, die auf der Leiterplatte angeordnet sein können. Deutlich zu erkennen ist wiederum der mechanisch sicher eingeklemmte elektrische Leiter 7, der durch das Klemmelement 1 und die daran ausgebildeten Leitertaschen 5 gehalten wird. Die Leitertaschen 5 begrenzen die Kontaktfläche 8 des Klemmelementes 1 derart, dass das Klemmelement 1 spielfrei in dem Aufnahmeelement 10 der Leiterplatte 9 gelagert ist. Die mechanische Befestigung des Klemmelementes 1 wird darüber hinaus durch die Sicherungskrallen 4 gewährleistet, die im Bereich des Aufnahmeelementes 10 in die Leiterplatte 9 eingepresst sind.

## Patentansprüche

1. Klemmelement (1) zur Befestigung eines elektrischen Leiters (7) an einer Leiterplatte (9), wobei mittels des Klemmelementes (1) und zwischen dem elektrischen Leiter (7) und der Leiterplatte (9) eine elektrisch leitende Verbindung hergestellt wird, wobei das Klemmelement (1) als Stanzblechteil ausgebildet ist und mindestens zwei Klemmflügel (2) sowie einen Klemmsteg (3), der zwischen den Klemmflügeln (2) angeordnet ist, aufweist, wobei der Klemmsteg (3) derart abbiegbar ist, dass die Klemmflügel (2) den Leiter (7) einklemmen, **dadurch gekennzeichnet, dass** an den Klemmflügeln (2) mindestens eine Sicherungskralle (4) ausgebildet ist, die in die Leiterplatte (9) einpressbar ist und wobei die Klemmflügel (2) eine Leitertasche (5) aufweisen, die den Leiter (7) umschließt.

2. Klemmelement (1) nach Anspruch 1, **dadurch gekennzeichnet, dass** die Klemmflügel (2) einen Klemmflügelbogen (6) aufweisen, der eine gefederte Lagerung des Leiters (7) ermöglicht.

3. Klemmelement (1) nach Anspruch 1 oder 2, **dadurch gekennzeichnet , dass** die Klemmflügel (2) eine Kontaktfläche (8) aufweisen.

4. Befestigungssystem für einen elektrischen Leiter (7) an einer Leiterplatte (9), mit einem Klemmelement nach einem der Ansprüche 1 bis 3, **dadurch gekennzeichnet, dass** an der Leiterplatte (9) ein Aufnahmeelement (10) mit einer elektrisch leitenden Oberfläche ausgebildet ist, in das das Klemmelement (1) eingeführt ist.

5. Befestigungssystem für einen elektrischen Leiter (7) an einer Leiterplatte (9) nach Anspruch 4, **dadurch gekennzeichnet , dass** das Aufnahmeelement (10) U-förmig ausgebildet ist.

6. Verfahren zur Befestigung eines elektrischen Leiters (7) an einer Leiterplatte (9), wobei der elektrischen Leiter (7) in ein Klemmelement (1) nach einem der Ansprüche 1 bis 5 eingeklemmt wird, was durch ein Abbiegen der Klemmsteges (3) erreicht wird, wobei der elektrischen Leiter (7) zwischen den Klemmflügeln (2) eingeklemmt wird, wonach das Klemmelement (7) in ein Aufnahmeelement (10) eingeschoben wird und wonach die Sicherungskralle (4) in die Leiterplatte (9) eingepresst oder eingeschlagen wird.

## Claims

1. Clamping element (1) for fastening an electrical conductor (7) to a printed circuit board (9), an electrically conductive connection being produced by means of the clamping element (1) and between the electrical conductor (7) and the printed circuit board (9), the clamping element (1) being in the form of a stamped sheet-metal part and has at least two clamping wings (2) and one clamping web (3), which is arranged between the clamping wings (2), the clamping web (3) being capable of being bent in such a way that the clamping wings (2) clamp in the conductor (7), **characterized in that** at least one securing claw (4) is formed on the clamping wings (2), it being possible for said securing claw to be pressed into the printed circuit board (9) and the clamping wings (2) have a conductor pocket (5) which surrounds the conductor (7).

2. Clamping element (1) according to Claim 1, **characterized in that** the clamping wings (2) have a clamping wing arch (6), which makes it possible for the conductor (7) to be mounted in a sprung manner.

3. Clamping element (1) according to Claim 1 or 2, **characterized in that** the clamping wings (2) have a contact face (8).

4. Fastening system for an electrical conductor (7) on a printed circuit board (9), with a clamping element according to one of Claims 1 to 3, **characterized in that** a receiving element (10) with an electrically conductive surface is formed on the printed circuit board (9), with the clamping element (1) being inserted into said receiving element.

5. Fastening system for an electrical conductor (7) on a printed circuit board (9) according to Claim 4, **characterized in that** the receiving element (10) is in the form of a U.

6. Method for fastening an electrical conductor (7) on a printed circuit board (9), the electrical conductor (7) being clamped into a clamping element (1) according to one of Claims 1 to 5, which is achieved by virtue of the clamping web (3) being bent back, the electrical conductor (7) being clamped in between the clamping wings (2), whereupon the clamping element (7) is pushed into a receiving element (10), and whereupon the securing claw (4) is pressed or driven into the printed circuit board (9).

## Revendications

1. Elément (1) de serrage pour la fixation d'un conducteur (7) électrique à une plaquette (9) à circuit imprimé, dans lequel on ménage, au moyen de l'élément (1) de serrage, une liaison conductrice de l'électricité entre le conducteur (7) électrique et la plaquette (9) à circuit imprimé, l'élément (1) de serrage étant constitué sous la forme d'une pièce en tôle à estamper et ayant au moins deux ailes (2) de serrage ainsi qu'une âme (3) de serrage, qui est disposée entre les deux ailes (2) de serrage, l'âme (3) de serrage pouvant être courbée de manière à ce que les ailes (2) de serrage serrent le conducteur (7), **caractérisé en ce qu'**il est formé, sur les ailes (2) de serrage, au moins un crampon (4) de sécurité, qui peut être enfoncé dans la plaquette (9) à circuit imprimé, les ailes (2) de serrage ayant une poche (5) qui enferme le conducteur (7).

2. Elément (1) de serrage suivant la revendication 1, **caractérisé en ce que** les ailes (2) de serrage ont un arceau (6), qui rend possible un montage suspendu du conducteur (7).

3. Elément (1) de serrage suivant la revendication 1 ou 2, **caractérisé en ce que** les ailes (2) de serrage ont une surface (8) de contact.

4. Système de fixation d'un conducteur (7) électrique à une plaquette (9) à circuit imprimé, comprenant un élément de serrage suivant l'une des revendications 1 à 3, **caractérisé en ce qu'**il est formé, sur la plaquette (9) à circuit imprimé, un élément (10) de réception ayant une surface conductrice de l'électricité, dans lequel l'élément (1) de serrage est introduit.

5. Système de fixation d'un conducteur (7) électrique à une plaquette (9) à circuit imprimé suivant la revendication 4, **caractérisé en ce que** l'élément (10) de réception est en forme de U.

6. Procédé de fixation d'un conducteur (7) électrique à une plaquette (9) à circuit imprimé, le conducteur (7) électrique étant serré dans un élément (1) de serrage suivant l'une des revendications 1 à 5, ce qui est obtenu par une flexion de l'âme (3) de serrage, le conducteur (7) électrique étant serré entre les ailes (2) de serrage, puis l'élément (7) de serrage est introduit dans un élément (10) de réception et ensuite le crampon (4) de sécurité est enfoncé dans la plaquette (9) à circuit imprimé ou y est pressé.
